# FASCICULE DE BREVET EUROPEEN

(11) **EP 2 616 386 B1**
(45) Date de publication et mention de la délivrance du brevet: **16.07.2014**
(21) Numéro de dépôt: 11754677.0
(22) Date de dépôt: 09.09.2011
(51) Int. Cl.: B81B 3/00

(54) **DISPOSITIF RESONANT A ACTIONNEMENT DANS LE PLAN, ET PROCEDE DE FABRICATION DU DISPOSITIF**
IN DER EBENE BETÄTIGTE RESONANZVORRICHTUNG UND VERFAHREN ZUR HERSTELLUNG DER VORRICHTUNG
IN-PLANE ACTUATED RESONANT DEVICE AND METHOD OF MANUFACTURING THE DEVICE

(30) Priorité: 13.09.2010 FR 1057252
(43) Date de publication de la demande: 24.07.2013
(73) Titulaire: Commissariat à l'Énergie Atomique et aux Énergies Alternatives, 75015 Paris (FR)
(72) Inventeur: HENTZ, Sébastien, F-38000 Grenoble (FR)
(74) Mandataire: Ilgart, Jean-Christophe
(86) Numéro de dépôt international: PCT/EP2011/065682
(87) Numéro de publication internationale: WO 2012/034949

(56) Documents cités:
- EP-A2- 1 316 977
- EP-A2- 2 008 965
- DE-A1- 19 812 773
- US-A1- 2002 194 942

## Description

### DOMAINE TECHNIQUE

La présente invention concerne un dispositif résonant à actionnement dans le plan, ainsi qu'un procédé de fabrication de ce dispositif.

L'invention trouve des applications notamment dans le domaine des dispositifs résonants de type MEMS (pour « Micro-Electro-Mechanical Systems ») ou de type NEMS (pour « Nano-Electro-Mechanichal Systems »).

Elle s'applique par exemple aux capteurs résonants, notamment aux capteurs de masse.

### ÉTAT DE LA TECHNIQUE ANTÉRIEURE

Aux échelles nanométriques, la question du choix de la transduction reste ouverte, non seulement en ce qui concerne le choix de la détection du mouvement du résonateur, mais aussi en ce qui concerne son actionnement.

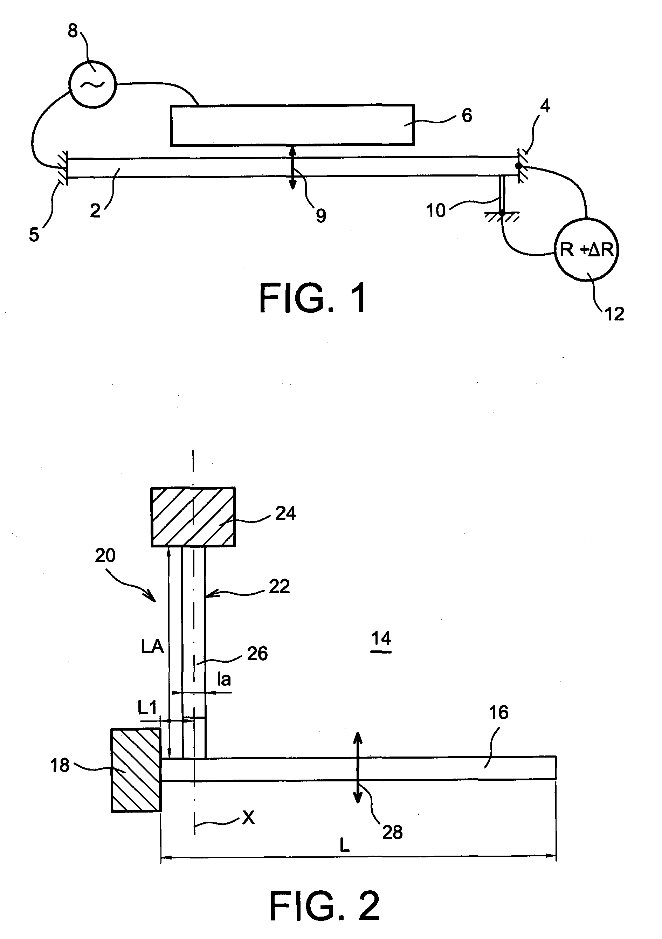

Les types d'actionnement les plus utilisés dans le domaine des MEMS et même des NEMS sont les actionnements électrostatique, thermoélastique et piézoélectrique, au sujet desquels on se reportera respectivement aux documents suivants :
[1] E. Mile et al., Nanotechnology, Vol. 21 Issue 16, pp. 165504 (2010)
[2] M. Li et al., Nature Nanotechnology, 2, 114-120 (2006)
[3] R. B. Karabalin et al., Applied Physics Letters, 95, 03111 (2009).
   Seul l'actionnement électrostatique permet d'obtenir facilement un mouvement du résonateur dans le plan, grâce à l'utilisation d'une ou plusieurs électrodes gravées et isolées. La figure 1 montre un exemple d'une telle utilisation.
   Cette figure est une vue de dessus schématique d'un dispositif résonant connu, décrit dans le document suivant auquel on se reportera :
[4] US 2008/0314148**,** invention de P. Robert, correspondant à EP 2008965.

Ce dispositif connu est formé sur un substrat et comprend :
- un résonateur 2, en forme de poutre, relié au substrat par au moins un encastrement 4 (en fait, dans l'exemple représenté, un deuxième encastrement 5 est prévu, comme on le voit),
- une électrode fixe 6 pour actionner le résonateur,
- une source de tension alternative 8, pour porter l'électrode à une tension alternative par rapport au résonateur, ce dernier vibrant alors parallèlement au plan de la surface du substrat, ce qui est symbolisé par la double flèche 9 de la figure 1,
- une jauge de contrainte suspendue 10, faite d'un matériau piézorésistif, et
- des moyens 12 de mesure de la contrainte subie par la jauge 10.

On notera que cette dernière est reliée au résonateur 2 en un point qui est situé en dehors de l'encastrement 4. On dispose ainsi d'un bras de levier qui permet d'augmenter la contrainte subie par cette jauge.

Un mouvement dans le plan peut être recherché pour de nombreuses raisons, notamment la liberté qu'un tel mouvement permet pour le choix du type de détection.

Ce peut être, par exemple, une détection à l'aide d'une ou plusieurs jauges piézorésistives semiconductrices gravées, ce qui est le cas du dispositif représenté sur la figure 1.

Une autre raison est relative à la conception du résonateur à mouvement dans le plan.

Par exemple, la fréquence de résonance du résonateur est indépendante de l'épaisseur de ce dernier lorsqu'il vibre dans le plan. Ainsi, le procédé de fabrication (ou d'autres contraintes) peut déterminer les épaisseurs des différents matériaux constitutifs du résonateur, tout en n'ayant que peu d'influence sur la fréquence de résonance de celui-ci.

En revanche, l'utilisation d'un actionnement électrostatique impose la présence d'un entrefer. Ce dernier doit être suffisamment faible pour minimiser la tension d'actionnement, mais suffisamment important pour permettre une grande amplitude de mouvement et maximiser ainsi le rapport signal sur bruit.

Il est en revanche compliqué d'obtenir une vibration de grande amplitude dans le plan lorsqu'on utilise un actionnement piézoélectrique ou thermoélastique. En effet, un tel actionnement ne permet généralement d'atteindre que de très faibles déformations, de l'ordre de quelques dixièmes de pourcent.

Ceci est vrai pour un résonateur de taille micrométrique, pour lequel de grandes amplitudes ne sont atteintes qu'en utilisant une structure très complexe. Mais c'est encore plus vrai pour un résonateur de plus petite taille, en particulier pour un résonateur de taille nanométrique. En effet, l'une des dimensions d'un tel résonateur, comptée parallèlement au plan du sutrat sur lequel il est formé, est souvent à la limite de ce que les techniques de fabrication connues permettent d'obtenir.

On sait qu'un actionnement piézoélectrique nécessite au moins trois couches : une couche piézoélectrique entre deux couches conductrices qui constituent respectivement des électrodes inférieure et supérieure. La reprise des contacts se fait donc verticalement. Il est alors nécessaire d'avoir accès à l'électrode inférieure pour polariser le dispositif. A ce sujet, on se reportera au document [3].

A l'inverse, un actionneur thermoélastique comporte un seul matériau, à travers lequel il est nécessaire de faire passer un courant électrique pour faire varier la température de ce matériau de manière alternative. Un tel actionneur nécessite donc deux connexions au même niveau technologique, dans le plan du substrat.

Ainsi, ces actionnements piézoélectrique et thermoélastique ont des effets mécaniques similaires sur le résonateur que l'on veut actionner, mais ont chacun leurs propres avantages et inconvénients.

Dans le cas d'un résonateur ayant des dimensions nanométriques ou des dimensions se situant aux limites autorisées par les techniques connues de fabrication, il est donc très difficile, voire impossible, d'utiliser ces deux types d'actionnement pour obtenir un mouvement dans le plan.

### EXPOSÉ DE L'INVENTION

La présente invention a pour but de remédier à cet inconvénient.

Elle exploite le fait que des moyens d'actionnement de type thermoélastique ou piézoélectrique ne permettent d'obtenir que de très faibles déformations mais permettent d'atteindre de hauts niveaux de contrainte.

Selon l'invention, les moyens d'actionnement d'une poutre formant le résonateur sont découplés de la poutre afin que cette dernière puisse avoir une taille que la technique de fabrication utilisée permet d'obtenir, et afin de pouvoir placer la poutre là où les déplacements de cette dernière sont faibles, c'est-à-dire à proximité d'un ancrage de la poutre.

On précise que la présente invention n'est pas limitée à des dispositifs résonants de dimensions nanométriques (NEMS) : elle s'applique également à des dispositifs résonants de dimensions supérieures, notamment de dimensions micrométriques (MEMS).

De façon précise, la présente invention a pour objet un dispositif résonant, à actionnement dans le plan, le dispositif comprenant :
- un support comportant une surface sensiblement plane,
- une poutre qui est suspendue vis-à-vis du support, apte à se déplacer parallèlement au plan de la surface du support, et ancrée au support par au moins l'une de ses extrémités, et
- des moyens d'actionnement de la poutre pour en permettre le déplacement parallèlement au plan de la surface du support,
caractérisé en ce que les moyens d'actionnement comprennent au moins un élément qui est suspendu vis-à-vis du support et qui est ancré, d'une part, au support et, d'autre part, à l'une des faces latérales de la poutre, l'élément suspendu étant apte à se déplacer lorsqu'on lui applique une tension de commande, et à causer ainsi le déplacement de la poutre.

Certes, on connaît, par le document DE 198 12 773 **correspondant à** US 6 389 898 de Seidel et al.**,** un microcapteur à structure résonante, comprenant un élément résonant et des moyens d'actionnement de cet élément ; mais ce dernier est ancré à un support par l'intermédiaire des moyens d'actionnement. Au contraire, dans le dispositif, objet de l'invention, la poutre, formant le résonateur, a ses propres moyens d'ancrage ; elle est ainsi ancrée au support indépendamment des moyens d'actionnement.

Selon un premier mode de réalisation préféré du dispositif, objet de l'invention, les moyens d'actionnement sont de type piézoélectrique, et l'élément suspendu comprend un empilement piézoélectrique.

Dans ce cas, selon un mode de réalisation particulier du dispositif, l'élément suspendu se rétrécit en une extrémité qui est ancrée à la face latérale de la poutre.

Selon un deuxième mode de réalisation préféré du dispositif, objet de l'invention, les moyens d'actionnement sont de type thermoélastique, et l'élément suspendu comprend une couche électriquement conductrice.

Selon un mode de réalisation particulier de l'invention, les moyens d'actionnement comprennent au moins deux éléments qui sont suspendus vis-à-vis du support et qui sont ancrés, d'une part, au support et, d'autre part, à l'une des faces latérales de la poutre, les éléments suspendus étant aptes à se déplacer lorsqu'on leur applique une tension de commande, et à causer ainsi le déplacement de la poutre.

Selon un mode de réalisation particulier du dispositif, objet de l'invention, ce dispositif comprend en outre des moyens de détection du déplacement de la poutre.

Les moyens de détection peuvent être choisis parmi des moyens de détection piézorésistive et des moyens de détection capacitive.

Dans le cas du premier mode de réalisation préféré, mentionné plus haut, les moyens de détection peuvent comprendre une jauge de détection de contrainte, constituée par l'élément suspendu.

La présente invention concerne aussi un procédé de fabrication du dispositif, objet de l'invention, dans lequel on forme la poutre et l'élément suspendu par une technologie de surface.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- la figure 1 est une vue de dessus schématique d'un dispositif résonant connu, et a déjà été décrite,
- la figure 2 à 8 sont des vues de dessus schématiques de modes de réalisation particuliers du dispositif, objet de l'invention,
- les figures 9A à 9G illustrent schématiquement diverses étapes d'un procédé de fabrication d'un dispositif conforme à l'invention, dans lequel l'actionnement est de type piézoélectrique, et
- les figures 10A à 10E illustrent schématiquement diverses étapes d'un autre procédé de fabrication d'un dispositif conforme à l'invention, dans lequel l'actionnement est de type thermoélectrique.

### EXPOSÉ DÉTAILLÉ DE MODES DE RÉALISATION PARTICULIERS

La figure 2 est une vue de dessus schématique d'un mode de réalisation particulier du dispositif résonant, objet de l'invention.

Le dispositif représenté sur cette figure comprend :
- un support 14, ou substrat, dont la surface est sensiblement plane,
- une poutre 16, formant un résonateur, qui est suspendue vis-à-vis du support, apte à se déplacer parallèlement au plan de la surface du support, et pourvue d'un ancrage 18 au support, en l'une de ses extrémités,
- des moyens 20 d'actionnement de la poutre pour en permettre le déplacement parallèlement au plan de la surface du support, et
- des moyens de détection du déplacement de la poutre.

Ces moyens de détection ne sont pas représentés sur la figure 2 mais des exemples de tels moyens seront donnés ultérieurement en faisant référence à d'autres figures.

Dans l'exemple de la figure 2, les moyens d'actionnement 20 comprennent un élément en forme de poutre 22. Cette dernière est suspendue vis-à-vis du support 14 et lui est ancrée par une extrémité. L'ancrage a la référence 24. La poutre 22 est également ancrée à l'une des faces latérales de la poutre 16, à proximité de l'ancrage 18, comme on le voit.

La poutre suspendue 22 est apte à se déplacer lorsqu'on lui applique une tension de commande, et à causer ainsi le déplacement de la poutre 16. Pour ce faire, dans l'exemple de la figure 2, on utilise des moyens d'actionnement de type piézoélectrique : la poutre 22 est pourvue d'un empilement piézoélectrique 26.

De façon connue, cet empilement comporte une couche piézoélectrique entre une couche conductrice inférieure et une couche conductrice supérieure qui est la seule couche visible sur la vue de dessus de la figure 2.

Les moyens permettant l'application de la tension de commande entre les deux couches conductrices ne sont pas représentés. Cette tension est alternative pour faire vibrer la poutre 16. Ses vibrations sont symbolisées par la double flèche 28 de la figure 2.

Comme on le voit, l'empilement 26 est formé sur toute la largeur la de la couche structurelle qui constitue la poutre 22 ainsi que la poutre 16 formant le résonateur. On précise que l'on donne à la une valeur suffisamment grande pour permettre la formation de l'empilement piézoélectrique.

La fréquence de polarisation de l'empilement piézoélectrique (fréquence de la tension de commande) permet la résonance de la poutre 16 sur le mode souhaité. L'amplitude de vibration souhaitée est obtenue en choisissant la position de l'ancrage de la poutre 22 sur la poutre 16, la valeur de la tension de commande et la longueur LA de la poutre 22.

En effet, l'application de la tension à l'empilement 26 entraîne une déformation s suivant l'axe X de la poutre 22. Le déplacement d obtenu à l'extrémité de la poutre 22 est donc égal à LAxε.

Typiquement, la distance L1 entre l'ancrage 18 et la ligne neutre (mi-largeur) de la poutre 22 est choisie égale au dixième de la longueur L de la poutre 16 ; et la valeur de la tension utilisée va typiquement de 10mV à quelques volts.

La largeur la de la poutre 22 peut être la dimension minimale permise par le procédé de formation de l'empilement piézoélectrique 26. Cependant, elle doit être suffisamment petite devant la longueur totale L du résonateur afin de ne pas gêner le mouvement de ce dernier (et aussi bien sûr afin d'être libérée vis-à-vis du substrat 14).

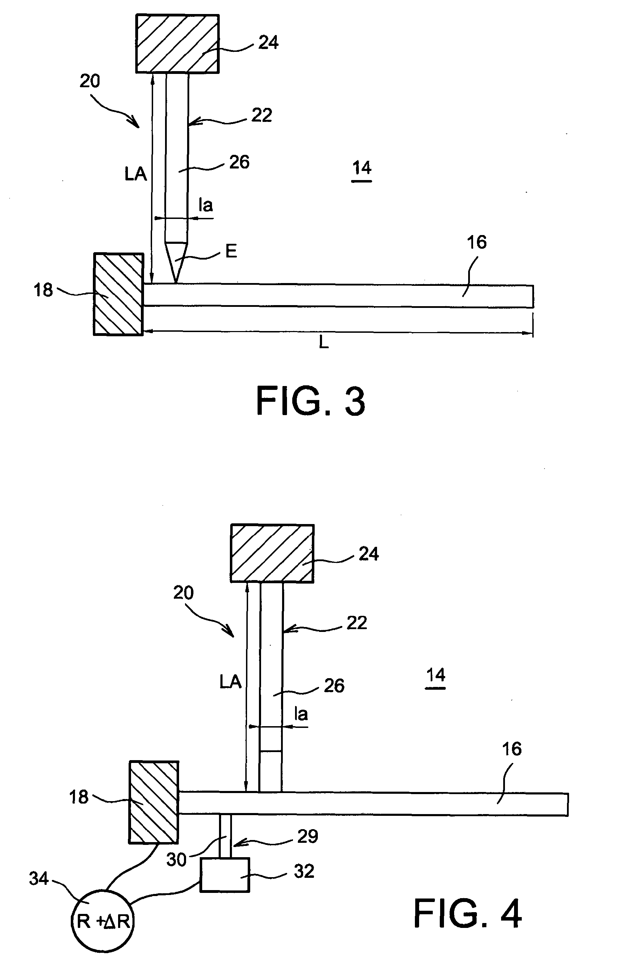

Si la largeur la n'est pas suffisamment petite devant L, la poutre 22 peut être rétrécie en son extrémité E qui est ancrée à la poutre 16, comme on le voit sur la vue de dessus de la figure 3.

L'actionnement utilisé dans la présente invention ne change en rien la méthode de détection du déplacement du résonateur. Cette détection peut, par exemple, être piézorésistive ou capacitive.

La figure 4 illustre schématiquement une détection piézorésistive. On y voit le dispositif de la figure 3, auquel on a ajouté des moyens de détection 29 comprenant une jauge piézorésistive 30 dont une extrémité est fixée à la poutre 16 et l'autre extrémité est ancrée au support 14. L'ancrage correspondant a la référence 32.

Des moyens de lecture classiques 34, comprenant par exemple un pont de Wheatstone (voir document [4]) sont connectés entre les ancrages 32 et 18 alors supposés électriquement conducteurs.

Sur la figure 4, la poutre 22 et la jauge 30 sont placées de part et d'autre de la poutre 16 et la jauge 30 est plus proche de l'ancrage 18 que la poutre 22. Toutefois, cette dernière et la jauge pourraient être du même côté de la poutre 16 ; et la poutre 22 pourrait être plus proche de l'ancrage 18 que la jauge 30.

Dans un autre mode de réalisation particulier, on utilise l'empilement piézoélectrique 26, que comporte la poutre 22, en tant que jauge de détection de contrainte, pour détecter le déplacement de la poutre 16 ; il s'agit alors d'une mesure piézoélectrique du déplacement.

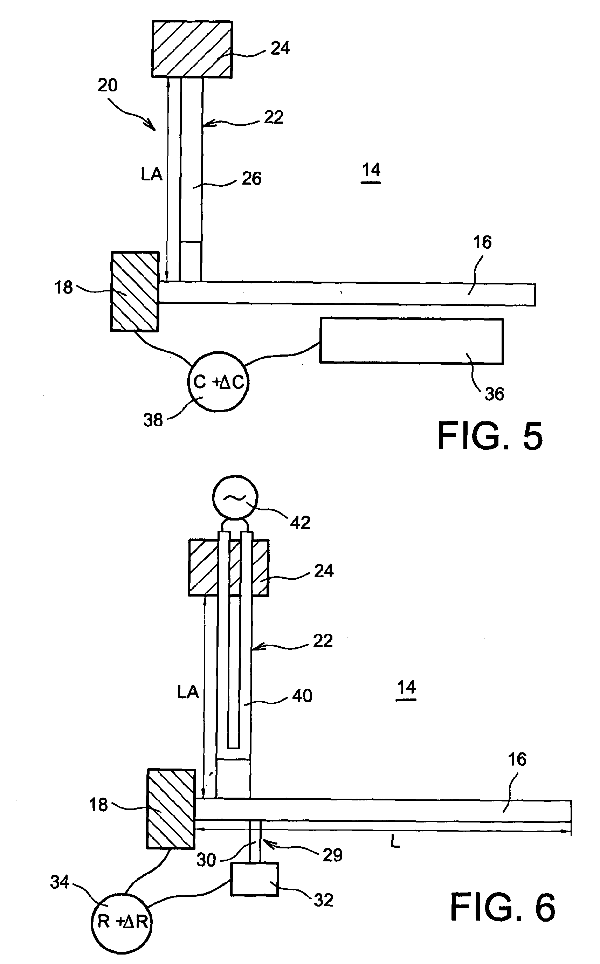

La figure 5 Ilustre schématiquement une détection capacitive. On y voit le dispositif de la figure 3, auquel on a ajouté des moyens de détection comprenant une électrode 36 fixée au substrat 14, à proximité de la poutre 16.

Des moyens de lecture classiques 38, pour mesurer une variation de capacité lorsque la poutre 16 vibre, sont connectés entre l'électrode 36 et l'ancrage 18 alors supposé électriquement conducteur.

La figure 6 est une vue de dessus schématique d'un autre exemple de l'invention, dans lequel les moyens d'actionnement sont de type thermoélastique. En outre, dans l'exemple représenté, on utilise une détection piézorésistive du déplacement de la poutre 16, comme dans le cas de la figure 4.

L'exemple de la figure 6 diffère ainsi de l'exemple de la figure 4 en ce que l'on a remplacé l'empilement piézoélectrique par une couche conductrice 40, formée sur la couche structurelle de la poutre 22. Comme précédemment, la largeur de cette dernière est supposée suffisante pour pouvoir former la couche 40.

Dans l'exemple représenté sur la figure 6, on utilise un actionnement thermoélastique « en boucle » : comme on le voit, la couche 40 forme une boucle qui commence au niveau de l'ancrage 24, s'étend le long de la poutre 22 puis revient au niveau de l'ancrage 24 supposé électriquement isolant ou isolé de la couche 40 en forme de boucle.

Une source appropriée de tension alternative 42 est connectée entre les deux extrémités de la couche 40 pour chauffer cette dernière en y faisant circuler un courant, en vue d'actionner la poutre 16.

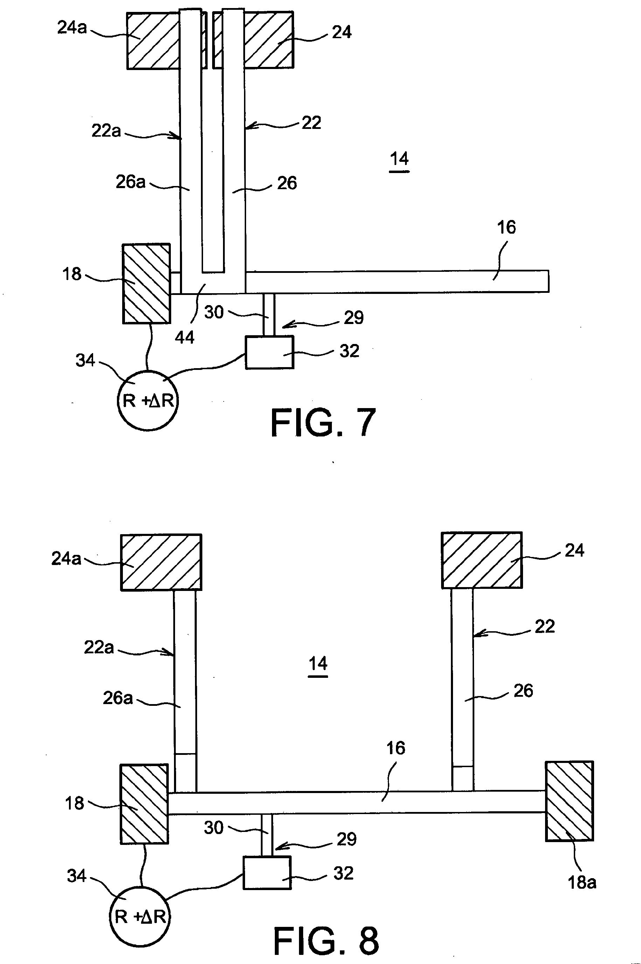

La figure 7 est une vue de dessus schématique d'un autre exemple de l'invention, dans lequel l'élément suspendu comporte deux branches alors qu'il n'en comportait qu'une dans le cas de la figure 4.

Plus précisément, sur la figure 7, on retrouve la poutre 22, l'ancrage 24 et l'empilement 26 de la figure 4, auxquels on ajoute une poutre parallèle 22a. Comme on le voit, cette dernière est ancrée, d'un côté, à la poutre 16 et, de l'autre côté, au substrat 14 par un ancrage 24a. L'empilement piézorésistif formé sur la couche structurelle de la poutre 22a a la référence 26a.

De plus, comme on le voit, une portion d'empilement piézorésistif 44 est formée sur la poutre 16 (on a gravé la couche structurelle correspondante à cet effet). Cette portion 44 relie les empilements 26 et 26a.

La figure 8 est une vue de dessus schématique d'un autre exemple de l'invention, dans lequel on utilise deux éléments suspendus, au lieu d'un seul élément, pour actionner la poutre 16 formant un résonateur.

Dans l'exemple de la figure 8, l'actionnement est de type piézoélectrique mais il pourrait être thermoélastique.

De plus, dans cet exemple, la poutre 16 est pourvue de deux ancrages 18 et 18a au substrat 14, en ses deux extrémités.

Cet exemple de la figure 8 se distingue de l'exemple de la figure 7 en ce que les poutres 22 et 22a sont plus espacées l'une de l'autre que dans le cas de la figure 7, et en ce que leurs empilements respectifs 26 et 26a ne sont pas reliés l'un à l'autre par une portion d'empilement piézorésistif.

Il est alors possible d'appliquer, respectivement aux deux poutres 22 et 22a, deux tensions de commande différentes, dont les fréquences respectives peuvent être différentes.

Un dispositif conforme à l'invention peut être fabriqué par une technologie de surface.

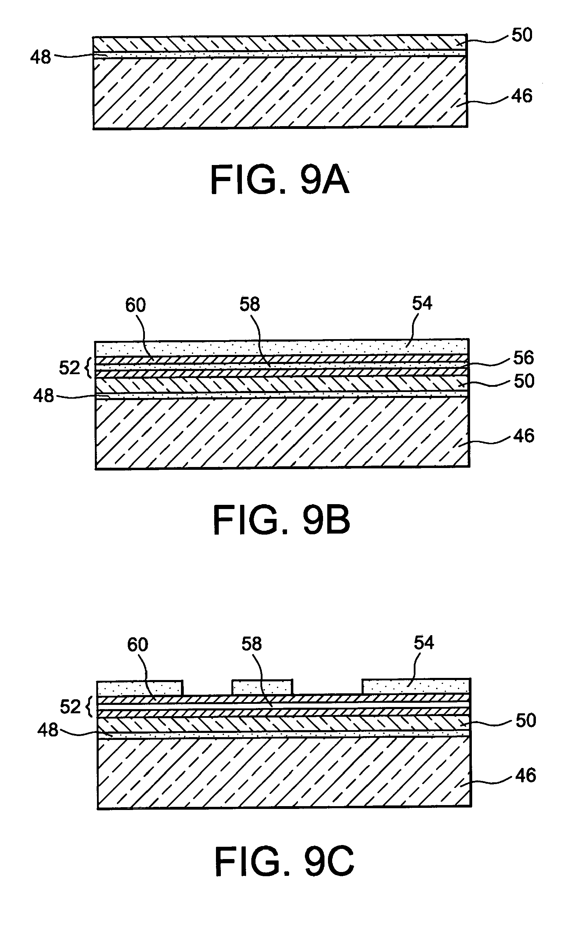

Un exemple de procédé de fabrication est schématiquement et partiellement illustré par les figures 9A à 9G dans le cas d'un actionnement de type piézoélectrique.

On utilise (figure 9A) un substrat SOI comprenant un substrat de base 46 en silicium, une couche sacrificielle 48 en SiO₂, dont l'épaisseur vaut par exemple 0,4 µm, et une couche de silicium 50 dont l'épaisseur vaut par exemple 0,16 µm.

On commence (figure 9B) par déposer un empilement piézoélectrique 52 de Mo/AlN/Mo sur la couche 50 puis une couche 54 de SiO₂ formant un masque dur, sur l'empilement 52. La couche de Mo inférieure, la couche intermédiaire de AlN et la couche de Mo supérieure ont respectivement les références 56, 58 et 60.

On procède ensuite à une photolithographie et une gravure RIE (pour « Reactive Ion Etching ») du masque 54 (figure 9C), avec arrêt sur la couche 60.

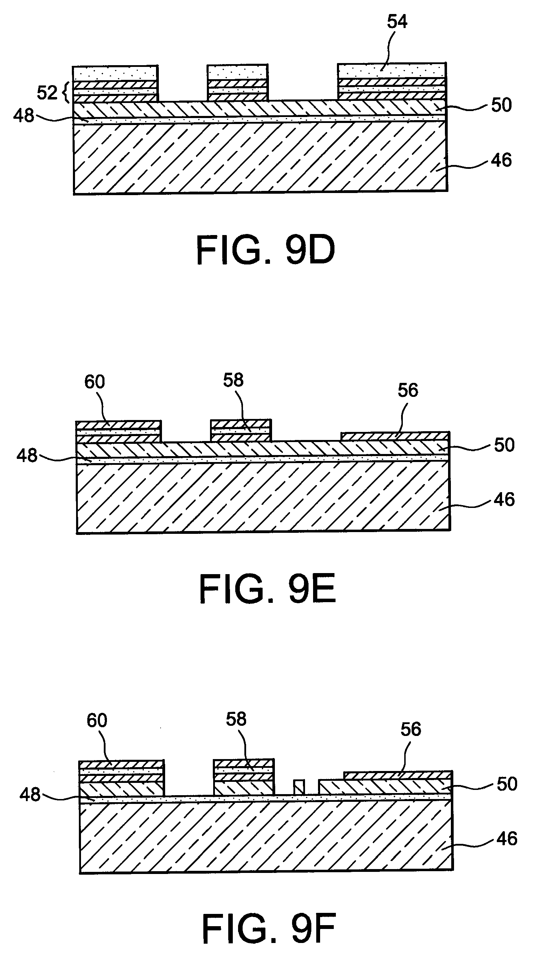

On procède ensuite (figure 9D) à une gravure sèche de l'empilement 52 avec arrêt sur la couche 50 en silicium.

Ensuite (figure 9E), on effectue une gravure de la couche supérieure de Mo et de la couche de AlN pour faire apparaître la couche inférieure de Mo et disposer ainsi de contacts électriques.

Puis (figure 9F), on procède à une photolithographie et une gravure RIE de la couche 50 de silicium, avec arrêt sur la couche 48.

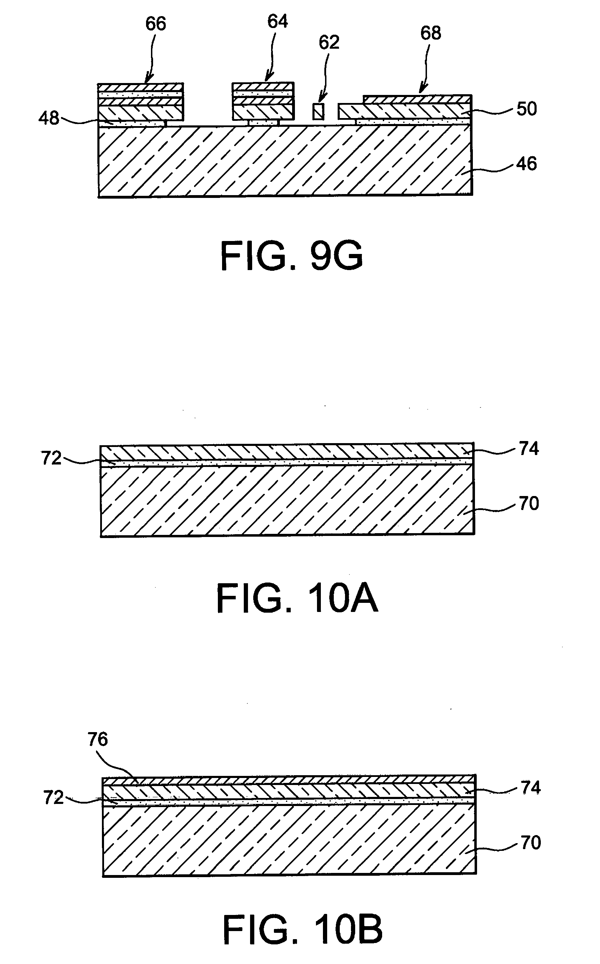

On libère ensuite (figure 9G) les composants du dispositif par exposition à l'acide fluorhydrique.

On obtient ainsi un résonateur 62 et un empilement piézoélectrique associé 64. Les références 66 et 68 correspondent respectivement aux contacts supérieur et inférieur (vus en coupe) qui sont nécessaire pour appliquer la tension de commande à l'empilement 64.

Un autre exemple de procédé de fabrication est schématiquement et partiellement illustré par les figures 10A à 10E dans le cas d'un actionnement de type thermoélastique.

On utilise encore (figure 10A) un substrat SOI comprenant un substrat de base 70 en silicium, une couche sacrificielle 72 en SiO₂, dont l'épaisseur vaut par exemple 0,4 µm, et une couche de silicium 74 dont l'épaisseur vaut par exemple 0,16 µm.

On commence (figure 10B) par déposer une couche métallique 76, par exemple en AlSi ou en Mo, sur la couche 74.

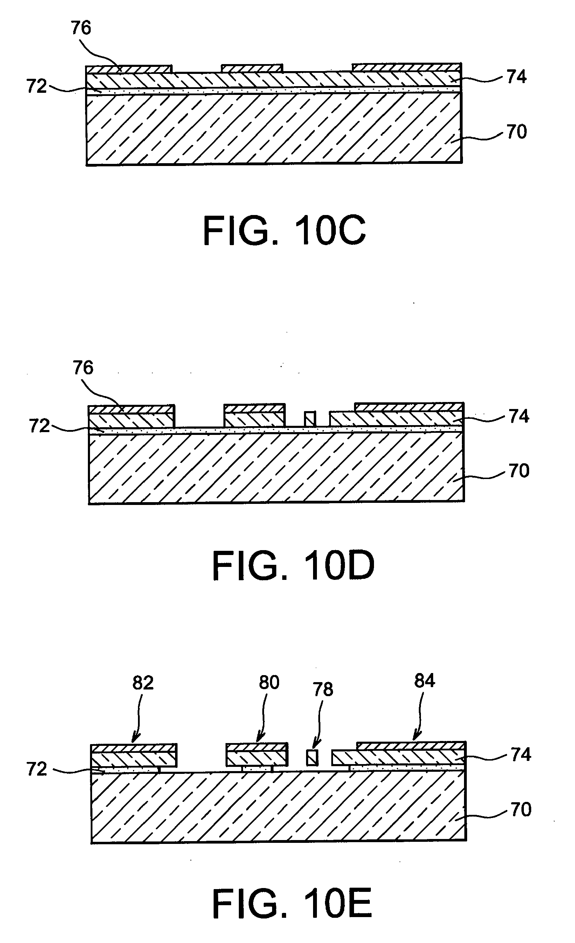

On procède ensuite à une photolithographie et une gravure de la couche métallique 76 (figure 10C), avec arrêt sur la couche 74 en silicium.

Ensuite, on procède à une photolithographie et une gravure RIE de la couche 74 en silicium (figure 10D), avec arrêt sur la couche 72.

Comme précédemment, on libère ensuite (figure 10E) les composants du dispositif par exposition à l'acide fluorhydrique.

On obtient ainsi un résonateur 78 et une couche conductrice associée 80. Les références 82 et 84 correspondent respectivement à des portions conductrices (vues en coupe) permettant d'appliquer la tension de commande à la couche 80.

Dans les exemples donnés plus haut, on a considéré des moyens d'actionnement de type piézoélectrique ou thermoélastique. Mais l'invention peut également être mise en oeuvre avec d'autres types de moyens d'actionnement.

Le ou les éléments suspendus (les poutres 22 et 22a en se référant aux exemples donnés) sont alors adaptés au type d'actionnement choisi.

## Revendications

1. Dispositif résonant, à actionnement dans le plan, le dispositif comprenant :
- un support (14) comportant une surface sensiblement plane,
- une poutre (16) formant un résonateur, qui est suspendue vis-à-vis du support, apte à se déplacer parallèlement au plan de la surface du support, et ancrée au support par au moins l'une de ses extrémités, et
- des moyens (20) d'actionnement de la poutre pour en permettre le déplacement parallèlement au plan de la surface du support,
**caractérisé en ce que** les moyens d'actionnement comprennent au moins un élément (22,22a) qui est suspendu vis-à-vis du support et qui est ancré, d'une part, au support et, d'autre part, à l'une des faces latérales de la poutre, l'élément suspendu étant apte à se déplacer lorsqu'on lui applique une tension de commande, et à causer ainsi le déplacement de la poutre.

2. Dispositif selon la revendication 1, dans lequel les moyens d'actionnement (20) sont de type piézoélectrique, et l'élément suspendu (22) comprend un empilement piézoélectrique (26).

3. Dispositif selon la revendication 2, dans lequel l'élément suspendu (22) se rétrécit en une extrémité (E) qui est ancrée à la face latérale de la poutre (16).

4. Dispositif selon la revendication 1, dans lequel les moyens d'actionnement (20) sont de type thermoélastique, et l'élément suspendu (22) comprend une couche électriquement conductrice (40).

5. Dispositif selon l'une quelconque des revendications 1 à 4, dans lequel les moyens d'actionnement comprennent au moins deux éléments (22,22a) qui sont suspendus vis-à-vis du support (14) et qui sont ancrés, d'une part, au support et, d'autre part, à l'une des faces latérales de la poutre (16), les éléments suspendus étant aptes à se déplacer lorsqu'on leur applique une tension de commande, et à causer ainsi le déplacement de la poutre.

6. Dispositif selon l'une quelconque des revendications 1 à 5, comprenant en outre des moyens (29) de détection du déplacement de la poutre.

7. Dispositif selon la revendication 6, dans lequel les moyens de détection (29) sont choisis parmi des moyens de détection piézorésistive et des moyens de détection capacitive.

8. Dispositif selon la revendication 6 et l'une quelconque des revendications 2 et 3, dans lequel les moyens de détection (29) comprennent une jauge de détection de contrainte, constituée par l'élément suspendu (22).

9. Procédé de fabrication du dispositif selon l'une quelconque des revendications 1 à 8, dans lequel on forme la poutre et l'élément suspendu par une technologie de surface.

## Patentansprüche

1. In der Ebene betätigte Resonanzvorrichtung, umfassend :
- einen Träger (14) mit einer im Wesentlichen ebenen Oberfläche,
- einen Balken (16), einen Resonator bildend, der dem Träger gegenüberliegend aufgehängt ist, sich parallel zu der Ebene der Oberfläche des Trägers bewegen kann und mit wenigstens einem seiner Enden am Träger befestigt ist, und
- Einrichtungen (20) zur Betätigung des Balkens, die ermöglichen, diesen parallel zu der Ebene der Oberfläche des Trägers zu bewegen,
**dadurch gekennzeichnet, dass** die Betätigungseinrichtungen wenigstens ein Element (22, 22a) umfassen, das dem Träger gegenüberliegend aufgehängt ist und das einerseits an dem Träger und andrerseits an bzw. bei einer der Stirnseiten des Balkens befestigt ist, wobei das aufgehängte Element fähig ist, sich zu bewegen, wenn man an es eine Steuerspannung anlegt und auf diese Weise die Bewegung des Balkens verursacht.

2. Vorrichtung nach Anspruch 1, bei der die Betätigungseinrichtungen (20) vom piezoelektrischen Typ sind und das aufgehängte Element (22) einen piezoelektrischen Stapel (26) umfasst.

3. Vorrichtung nach Anspruch 2, bei der das aufgehängte Element (22) sich an einem Ende (E) verjüngt, das an bzw. bei der Stirnseite des Balkens (16) befestigt ist.

4. Vorrichtung nach Anspruch 1, bei dem die Betätigungseinrichtungen (20) vom thermoelastischen Typ sind und das aufgehängte Element (22) eine elektrisch leitfähige Schicht (40) umfasst.

5. Vorrichtung nach einem der Ansprüche 1 bis 4, bei der die Betätigungseinrichtungen wenigstens zwei Elemente (22, 22a) umfassen, die dem Träger (14) gegenüberliegend aufgehängt sind und die einerseits an dem Träger und andrerseits an bzw. bei einer der Stirnseiten des Balkens (16) befestigt sind, wobei die aufgehängten Elemente fähig sind, sich zu bewegen, wenn man an sie eine Steuerspannung anlegt und auf diese Weise die Bewegung des Balkens verursacht.

6. Vorrichtung nach einem der Ansprüche 1 bis 5 mit außerdem Einrichtungen (29) zur Detektion der Bewegung des Balkens.

7. Vorrichtung nach Anspruch 6, bei der die Detektionseinrichtungen (29) ausgewählt werden unter piezoresistiven Detektionseinrichtungen und kapazitiven Detektionseinrichtungen.

8. Vorrichtung nach Anspruch 6 und einem der Ansprüche 2 und 3, bei der die Detektionseinrichtungen (29) einen Dehnungsmessstreifen umfassen, gebildet durch das aufgehängte Element (22).

9. Verfahren zur Herstellung der Vorrichtung nach einem der Ansprüche 1 bis 8, bei dem man den Balken und das aufgehängte Element durch eine Oberflächentechnologie bildet.

## Claims

1. In-plane actuated resonant device, comprising:
- a support (14) comprising an approximately plane surface,
- a beam (16) forming a resonator, suspended from the support, capable of moving parallel to the plane of the surface of the support and anchored to the support through at least one of its ends, and
- means (20) of actuating the beam to enable displacement parallel to the plane of the surface of the support,
**characterised in that** the actuation means comprise at least one element (22,22a) suspended from the support and anchored firstly to the support and secondly to one of the lateral faces of the beam, the suspended element being capable of moving when a control voltage is applied to it, thus causing displacement of the beam.

2. Device according to claim 1, in which the actuation means (20) are of the piezoelectric type and the suspended element (22) comprises a piezoelectric stack (26).

3. Device according to claim 2, in which the suspended element (22) becomes narrow at one end (E) anchored to the lateral face of the beam (16).

4. Device according to claim 1, in which the actuation means (20) are of the thermoelastic type, and the suspended element (22) comprises an electrically conducting layer (40).

5. Device according to any of claims 1 to 4, in which the actuation means comprise at least two elements (22, 22a) suspended from the support (14) and that are anchored firstly to the support and secondly to one of the lateral faces of the beam (16), the suspended elements being capable of moving when a control voltage is applied to them, and thus causing displacement of the beam.

6. Device according to any of claims 1 to 5, also comprising means (29) of detecting displacement of the beam.

7. Device according to claim 6, in which the detection means (29) are chosen from among piezoresistive detection means and capacitive detection means.

8. Device according to claim 6 and either claim 2 or 3, in which the detection means (29) comprise a strain detection gauge, composed of the suspended element (22).

9. Method of manufacturing the device according to any of claims 1 to 8, in which the beam and the suspended element are formed using surface technology.
